# EUROPÄISCHE PATENTSCHRIFT

(11) **EP 1 787 155 B1**
(45) Veröffentlichungstag und Bekanntmachung des Hinweises auf die Patenterteilung: **28.04.2010**
(21) Anmeldenummer: 05770748.1
(22) Anmeldetag: 22.07.2005
(51) Int. Cl.: G02B 17/08, H01L 33/00

(54) **SEITLICH EMITTIERENDES STRAHLUNGSERZEUGENDES BAUELEMENT UND LINSE FÜR EIN SOLCHES BAUELEMENT**
LATERALLY-EMITTING, RADIATION-GENERATING COMPONENT, AND LENS FOR ONE SUCH COMPONENT
COMPOSANT PRODUISANT UN RAYONNEMENT, A EMISSION LATERALE, ET LENTILLE POUR UN TEL COMPOSANT

(30) Priorität: 08.09.2004 DE 102004043516; 08.09.2004 US 607904 P
(43) Veröffentlichungstag der Anmeldung: 23.05.2007
(73) Patentinhaber: OSRAM Opto Semiconductors GmbH, 93055 Regensburg (DE)
(72) Erfinder: WANNINGER, Mario, 93055 Harting (DE)
(74) Vertreter: Lettenberger, Michael
(86) Internationale Anmeldenummer: PCT/DE2005/001292
(87) Internationale Veröffentlichungsnummer: WO 2006/026939

(56) Entgegenhaltungen:
- EP-A- 1 453 107
- WO-A-88/03658
- GB-A- 2 340 301

## Beschreibung

Diese Patentanmeldung beansprucht die Prioritäten der deutschen Patentanmeldung DE 102004043516.2 vom 8. September 2004 und der US-Patentanmeldung US 60/607,904 vom 8. September 2004.

Die Erfindung betrifft ein seitlich emittierendes strahlungserzeugendes Bauelement mit einer Strahlungsquelle, deren optische Achse senkrecht zu einer Montagefläche des Bauelements verläuft, und mit einer der Strahlungsquelle nachgeordneten optischen Einrichtung, die eine in diese eingekoppelte elektromagnetische Strahlung der Strahlungsquelle zur Seite hin umlenkt. Sie betrifft weiterhin eine separat gefertige Linse für ein solches Bauelement.

Montagefläche ist vorliegend diejenige äußere Oberfläche des Bauelements, die im auf einem Träger, beispielsweise auf einer elektrischen Leiterplatte montierten Zustand des Bauelements, dem Träger zugewandt ist.

Derartige Bauelemente und entsprechend geartete Linsen sind beispielsweise aus den Druckschriften US 6,679,621 B2, US 6,607,286 B2 und US 6,598,998 B2 bekannt. Die darin beschriebenen Bauelemente und Linsen weisen zum einen eine vergleichsweise große Bauhöhe auf und sind zum anderen nur mit technisch aufwändigen Mitteln herstellbar.

Es ist eine Aufgabe der vorliegenden Erfindung, ein Bauelement der eingangs genannten Art bereitzustellen, das eine möglichst geringe Bauhöhe aufweist und das mit geringerem technischen Aufwand herstellbar ist.

Diese Aufgabe wird durch ein Bauelement mit den Merkmalen des Patentanspruches 4 und durch eine Linse mit den Merkmalen des Patentanspruches 1 gelöst.

Vorteilhafte Weiterbildungen und Ausführungsformen des Bauelements und der Linse sind in den Unteransprüchen 2 und 3 angegeben.

Diese Aufgabe wird insbesondere durch ein Bauelement der eingangs genannten Art gelöst, bei dem die optische Einrichtung eine im Querschnitt V-artig, im rotationssymmetrischen Fall trichterartig geformte reflektierende Oberfläche und eine die reflektierende Oberfläche umschließende und von außerhalb gesehen konvex geformte refraktive Oberfläche aufweist, wobei die refraktive Oberfläche zwischen der reflektierenden Oberfläche und einer der Strahlungsquelle zugewandten Bodenfläche angeordnet ist. Die Bodenfläche ist dabei derart angeordnet und ausgebildet, dass durch sie elektromagnetische Strahlung der Strahlungsquelle in die optische Einrichtung einkoppelt, und die reflektierende Oberfläche ist derart angeordnet und ausgebildet, dass ein zentraler erster Teil eines eingekoppelten Strahlungskegels von dieser zur refraktiven Oberfläche hin umgelenkt wird. Die refraktive Oberfläche ist schließlich derart angeordnet und ausgebildet, dass sowohl eine von der reflektierenden Oberfläche her kommende Strahlung als auch eine direkt von der Strahlungsquelle her kommende Strahlung durch diese unter gleichzeitiger Strahlbündelung mit möglichst großem Winkel schräg zur optischen Achse der Strahlungsquelle ausgekoppelt wird.

Erfindungsgemäß "verarbeitet" die konvex gekrümmte refraktive Oberfläche beide Lichtbündel, das heißt sowohl dasjenige, welches von der reflektierenden Oberfläche stammt, als auch dasjenige, welches direkt, das heißt ohne dazwischen liegende gezielte Umlenkung an einer Oberfläche der optischen Einrichtung, von der Strahlungsquelle stammt. Die Auftreffbereiche der beiden Lichtbündel auf der konvexen refraktiven Oberfläche sind schwerpunktmäßig voneinander getrennt. Das von der reflektierenden Oberfläche umgelenkte Lichtbündel trifft auf einem der Bodenfläche benachbarten Bereich der refraktiven Oberfläche auf und wird von diesem gebrochen und gebündelt. Das direkt von der Strahlungsquelle stammende Lichtbündel trifft auf einem der reflektierenden Oberfläche benachbarten Bereich der refraktiven Oberfläche auf und wird von diesem gebrochen und gebündelt.

Der der Bodenfläche benachbarte Bereich und der der reflektierenden Oberfläche benachbarte Bereich der konvexen refraktiven Oberfläche haben im Schnitt jeweils eine Krümmung mit einem vergleichsweise großen Krümmungsradius und der Übergangsbereich zwischen diesen beiden Bereichen weist einen im Vergleich dazu geringen Krümmungsradius auf.

Bei der erfindungsgemäßen Ausgestaltung des Bauelements bzw. der Linse befindet sich im Übergangsbereich zwischen der reflektierenden Oberfläche und der refraktiven Oberfläche ein gegenüber der Strahlungsquelle abgeschatteter Oberflächenbereich der optischen Einrichtung bzw. Linse. Besonders bevorzugt ist der abgeschattete Bereich im wesentlichen ein Bereich der reflektierenden Oberfläche im Übergangsbereich zur refraktiven Oberfläche. Der abgeschattete Bereich kann als separate, von den benachbarten Oberflächen (reflektierende Oberfläche und refraktive Oberfläche) abgekantete Fläche oder mit fliessendem Übergang als Bestandteil einer der beiden benachbarten Oberflächen ausgeführt sein. Durch die Abschattung können vorteilhafterweise Rückreflexionen reduziert werden.

Die erfindungsgemäße optische Einrichtung/Linse ist in ihrer Form näherungsweise eine in einem Winkel > 0° zur optischen Achse der Strahlungsquelle nach außen gekippte refraktive Konvexlinse mit einer reflektierenden Rückseite, die Strahlung der Strahlungsquelle, die nach Eintritt durch die Bodenfläche nicht unmittelbar auf die refraktive Oberfläche der Linse gerichtet ist, zur Seite auf die refraktive Oberfläche hin umlenkt und dort unter gleichzeitiger Bündelung ausgekoppelt. Hierfür ist ein erster refraktiver Linsenbereich vorgesehen.

Eine direkt von der Strahlungsquelle auf einen vom ersten getrennten zweiten refraktiven Linsenbereich treffende Strahlung wird von letzterem unter gleichzeitiger Bündelung unmittelbar zur Seite des Bauelements hin umgelenkt. Die refraktive Oberfläche kann symmetrisch oder unsymmetrisch ausgebildet sein. Sie kann als Freiformlinse ausgebildet sein.

Zur Herstellung der Linse mittels Spritzgießen oder Spritzpressen kann vorteilhafterweise ein technisch einfaches Werkzeug verwendet werden, das insbesondere keinen technisch aufwändigen Schieber benötigt.

Die Linse kann separat hergestellt und als Aufsatzoptik auf ein Bauelementgehäuse aufgesetzt werden, mit oder ohne Brechungsindex-Anpassung. Sie kann aber auch direkt beispielsweise an einen Leuchtdiodenchip angegossen werden. Die Bodenfläche ist dann keine reale Oberfläche sondern nur eine gedachte Fläche.

Das erfindungsgemäße Bauelement kann mit Vorteil eingesetzt werden zum seitlichen Abstrahlen von Strahlung eines Top-Emitters, zum seitlichen Einkoppeln von Strahlung eines Top-Emitters in einen Lichtleiter, zum großflächigen Hinterleuchten von Anzeigen und Symbolen und von LCD-Displays, für Signalleuchten, zum homogenen Ausleuchten von Reflektoren und zur Ambientbeleuchtung. Die erfindungsgemäße optische Einrichtung kann in angepasster Form auch in Lichtleiter integriert werden.

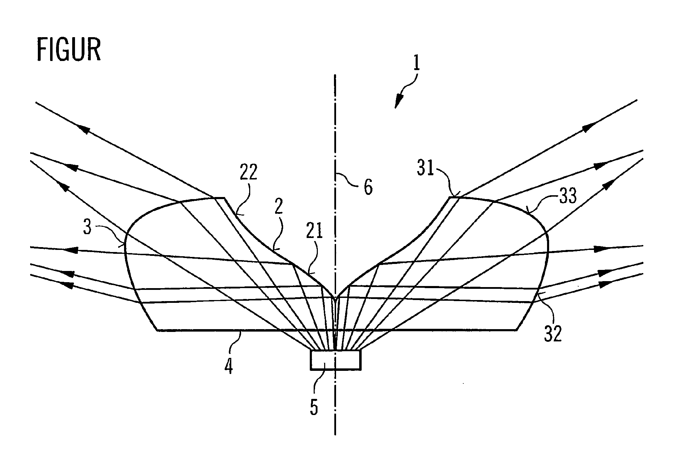

Weitere Vorteile, bevorzugte Ausführungsformen und Weiterbildungen des Bauelements und der Linse ergeben sich aus dem im Folgenden in Verbindung mit der Figur näher erläuterten Ausführungsbeispiel.

Die Figur zeigt eine schematische Schnittansicht durch ein Ausführungsbeispiel einer Linse für ein Bauelement gemäß der Erfindung.

Die Linse 1 gemäß dem Ausführungsbeispiel hat eine rotationssymmetrische Form mit einer von der Vorderseite der Linse in diese trichterartig geformten reflektierenden Oberfläche 2 und einer von außerhalb gesehen konvex geformten refraktiven Oberfläche 3, die zwischen der reflektierenden Oberfläche 2 und einer Bodenfläche 4 der Linse verläuft und diese miteinander verbindet. Die Bodenfläche 4 ist derart angeordnet und ausgebildet, dass durch sie elektromagnetische Strahlung einer vom Linseninneren gesehen hinter der Bodenfläche 4 angeordnete Strahlungsquelle 5, beispielsweise ein LED-Bauelement, in die Linse 1 einkoppelt.

Die reflektierende Oberfläche 2 ist derart angeordnet und ausgebildet, dass ein zentraler erster Teil der eingekoppelten Strahlung von dieser zu einem der Bodenfläche 4 benachbarten ersten Linsenbereich 32 der refraktiven Oberfläche 3 hin umgelenkt wird. Die refraktive Oberfläche 3 ist derart angeordnet und konvex ausgebildet, dass sowohl eine von der reflektierenden Oberfläche 2 her kommende Strahlung als auch eine direkt von der Strahlungsquelle 5 her kommende und auf einen der reflektierenden Oberfläche 2 benachbarten zweiten Linsenbereich 33 der refraktiven Oberfläche 3 treffende Strahlung durch diese unter gleichzeitiger Strahlbündelung seitlich zur optischen Achse 6 der Strahlungsquelle 5 ausgekoppelt wird. Der erste 32 und der zweite Linsenbereich 33 sind in Schnittansicht vergleichsweise schwach gekrümmt, der diese beiden Linsenbereiche 32,33 verbindende Übergangsbereich ist demgegenüber stark gekrümmt.

Die V-artig geformte reflektierende Oberfläche 2 ist derart S-artig gekrümmt, dass ein der optischen Achse 6 benachbarter erster Teilbereich 21 von außerhalb gesehen konvex gekrümmt und ein der refraktiven Oberfläche 3 benachbarter zweiter Teilbereich 22 von außerhalb gesehen derart konkav gekrümmt ist, dass ein vorderseitiger Randbereich 31 der refraktiven Oberfläche 3 gegen direkte Strahlung der Strahlungsquelle 5 abgeschattet ist. Der konvexe Teil der reflektierenden Oberfläche 2 bewirkt schon eine erste Bündelung einer auf ihn treffenden Strahlung der Strahlungsquelle.

Eine solche Linse gemäß dem Ausführungsbeispiel kann separat gefertigt und beispielsweise auf ein separat gefertigtes oberflächenmontierbares Toplooker-LED-Bauelement aufgesetzt werden. Dies kann beispielsweise mittels eines Klebstoffes erfolgen, dessen Brechungsindex vorzugsweise zwischen dem Brechungsindex eines Chip-Umhüllungsmaterials und dem des Linsenmaterials liegt. Weiterhin können an der Linse und am Bauelement-Gehäuse Justierelemente zum justierten Aufsetzen der Linse vorgesehen sein.

Ein geeignetes Ausführungsbeispiel für ein Toplooker-LED-Bauelement, auf den die Linse gemäß dem Ausführungsbeispiel aufgesetzt werden kann, ist beispielsweise in der WO 02/84749 A2 beschrieben.

Die Erfindung ist nicht durch die Beschreibung anhand der Ausführungsbeispiele beschränkt.

## Patentansprüche

1. Linse (1) für ein seitlich emittierendes strahlungserzeugendes Bauelement mit einer Strahlungsquelle (5), deren optische Achse (6) senkrecht zu einer Montagefläche des Bauelements verläuft, mit
- einer im Querschnitt V-artig geformten reflektierenden Oberfläche (2) und einer konvex geformten refraktiven Oberfläche (3), die zwischen der reflektierenden Oberfläche (2) und einer Bodenfläche (4) der Linse (1) angeordnet ist,
wobei
- die Bodenfläche (4) derart angeordnet und ausgebildet ist, dass durch sie elektromagnetische Strahlung der Strahlungsquelle (5) in die Linse (1) einkoppelt,
- die reflektierende Oberfläche (2) derart angeordnet und ausgebildet ist, dass ein zentraler erster Teil der eingekoppelten Strahlung von dieser zur refraktiven Oberfläche (3) hin umgelenkt wird, und
- die refraktive Oberfläche (3) derart angeordnet und ausgebildet ist, dass sowohl eine von der reflektierenden Oberfläche (2) her kommende Strahlung als auch eine direkt von der Strahlungsquelle (5) her kommende Strahlung durch diese unter gleichzeitiger Strahlbündelung seitlich zur optischen Achse (6) der Strahlungsquelle (5) ausgekoppelt wird,
**dadurch gekennzeichnet, dass**
mindestens ein Schenkel der V-artig geformten reflektierenden Oberfläche (2) derart S-artig gekrümmt ist, dass ein der optischen Achse benachbarter Teil (21) konvex gekrümmt und ein der refraktiven Oberfläche (3) benachbarter Teil (22) konkav gekrümmt ist, so dass ein vorderseitiger Randbereich der refraktiven Oberfläche (3) gegen direkte Strahlung der Strahlungsquelle (5) abgeschattet ist.

2. Linse (1) nach Anspruch 1, die rotationssymmetrisch um die optische Achse (6) der vorgesehenen Strahlungsquelle (5) ausgebildet ist.

3. Linse (1) nach Anspruch 1 oder 2, an der Justierelemente zum justierten Aufsetzen der Linse (1) vorgesehen sind.

4. Seitlich emittierendes strahlungserzeugendes Bauelement mit einer Strahlungsquelle(5), deren optische Achse senkrecht zu einer Montagefläche des Bauelements verläuft, und mit einer der Strahlungsquelle (5) nachgeordneten Linse (1) gemäß einem der vorhergehenden Ansprüche.

## Claims

1. Lens (1) for a laterally emitting radiation-generating component comprising a radiation source (5), the optical axis (6) of which runs perpendicular to a mounting area of the component, comprising
- a reflective surface (2) shaped like a V in cross section and a refractive surface (3) that is shaped convexly and is arranged between the reflective surface (2) and a bottom area (4) of the lens (1),
wherein
- the bottom area (4) is arranged and formed in such a way that through it electromagnetic radiation from the radiation source (5) couples into the lens (1),
- the reflective surface (2) is arranged and formed in such a way that a central first portion of the coupled-in radiation is deflected towards the refractive surface (3) by said reflective surface, and
- the refractive surface (3) is arranged and formed in such a way that both a radiation coming from the reflective surface (2) and a radiation coming directly from the radiation source (5) are coupled out through it with simultaneous beam focusing laterally with respect to the optical axis (6) of the radiation source (5),
**characterized in that**
at least one limb of the reflective surface (2) shaped like a V is curved like an S in such a way that a part (21) that is adjacent to the optical axis is curved convexly and a part (22) that is adjacent to the refractive surface (3) is curved concavely, such that a front-side edge region of the refractive surface (3) is shaded from direct radiation from the radiation source (5).

2. Lens (1) according to Claim 1, which is formed such that it is rotationally symmetrical about the optical axis (6) of the radiation source (5) provided.

3. Lens (1) according to Claim 1 or 2, at which alignment elements for aligned emplacement of the lens (1) are provided.

4. Laterally emitting radiation-generating component comprising a radiation source (5), the optical axis of which runs perpendicular to a mounting area of the component, and comprising a lens (1) according to any of the preceding claims, said lens being arranged downstream of the radiation source (5).

## Revendications

1. Lentille (1) pour un composant produisant un rayonnement à émission latérale avec une source de rayonnement (5) dont l'axe optique (6) s'étend perpendiculairement à une surface de montage du composant, avec
- une surface réfléchissante (2) dont la coupe est en forme de V et une surface réfractive (3) de forme convexe disposée entre la surface réfléchissante (2) et une surface de base (4) de la lentille (1), dans laquelle
- la surface de base (4) est disposée et réalisée de manière à coupler par son intermédiaire le rayonnement électromagnétique de la source de rayonnement (5) dans la lentille (1),
- la surface réfléchissante (2) est disposée et réalisée de manière à dévier une première partie centrale du rayonnement couplé à l'intérieur vers la surface réfractive (3), et
- la surface réfractive (3) est disposée et réalisée de manière à coupler vers l'extérieur, latéralement à l'axe optique (6) de la source de rayonnement (5), tout en le focalisant, un rayonnement provenant de la surface réfléchissante (2) au même titre qu'un rayonnement provenant directement de la source de rayonnement (5),
**caractérisé en ce que**
au moins un flanc de la surface réfléchissante (2) en forme de V est incurvé en forme de S de telle sorte qu'une partie (21) voisine de l'axe optique est incurvée de manière convexe et qu'une partie (22) voisine de la surface réfractive (3) est incurvée de manière concave, de telle sorte qu'une zone périphérique avant de la surface réfractive (3) soit masquée vis-à-vis du rayonnement direct de la source de rayonnement (5).

2. Lentille (1) selon la revendication 1, réalisée en symétrie de rotation autour de l'axe optique (6) de la source de rayonnement (5) prévue.

3. Lentille (1) selon la revendication 1 ou 2, dans laquelle on a prévu des éléments d'ajustement pour le montage ajusté de la lentille (1).

4. Composant produisant un rayonnement à émission latérale avec une source de rayonnement (5) dont l'axe optique s'étend perpendiculairement à une surface de montage du composant, et avec une lentille (1) disposée après la source de rayonnement (5) selon une des revendications précédentes.
